# EUROPEAN PATENT APPLICATION

(11) **EP 2 919 293 A1**
(43) Date of publication of application: **16.09.2015**
(21) Application number: 13853477.1
(22) Date of filing: 05.11.2013
(51) Int. Cl.: H01M 2/10, H01R 13/514, H01R 13/516

(54) **BATTERY SHELF ASSEMBLY, POWER STORAGE SYSTEM, AND ASSEMBLY METHOD OF BATTERY SHELF ASSEMBLY**

(30) Priority: 06.11.2012 JP 2012244925
(71) Applicant: NEC CORPORATION, Tokyo 108-8001 (JP)
(72) Inventor: HACHIYA, Kuniatsu, Tokyo 140-0002 (JP); HAMANO, Seiji, Tokyo 140-0002 (JP); HOSHIYA, Yuka, Tokyo 140-0002 (JP); KAWADA, Kouichi, Tokyo 140-0002 (JP); AKABA, Kunihiro, Tokyo 140-0002 (JP); ONO, Hironori, Tokyo 140-0002 (JP); USUI, Kenji, Tokyo 108-8001 (JP); YAMADA, Yousuke, Tokyo 108-8001 (JP)
(74) Representative: Vossius & Partner Patentanwälte Rechtsanwälte mbB
(86) International application number: PCT/JP2013/079875
(87) International publication number: WO 2014/073524

(57) **Abstract**

A battery shelf assembly (50) includes: a plurality of battery units (30); a battery shelf (55) accommodating the battery units (30), configured such that the battery units (30) are mounted or dismounted by sliding movement in the battery shelf; and a power connector (120) connecting the battery unit (30) and the battery shelf (55) so that power of the battery unit can be output. The power connector (120) has: a first connector member (121) disposed at an electrode terminal of the battery unit (30); a second connector member (131) disposed on the battery shelf side and configured to connect with the first connector member (121); and a floating structure that absorbs a position gap between the first and second connector members.

## Description

### TECHNICAL FIELD

The present invention relates to structure for a power storage system etc., and more particularly to a battery shelf assembly, which is excellent in work efficiency of mounting battery units as well as in maintainability, a power storage system, and an assembling method of a battery shelf assembly.

### BACKGROUND ART

Conventionally, it has been proposed to use a power storage system, which has a plurality of chargeable and dischargeable battery units, as a backup power source etc. for a computer system or a household. For example, Patent Document 1 discloses a power storage system in which a plurality of battery units and a control unit controlling the battery units are housed in one housing case.

### PRIOR ART REFERENCE

Patent Document 1: Japanese Patent Laid-Open No. 2012-9309

### SUMMARY OF INVENTION

### TECHNICAL PROBLEM

While the configuration illustrated in Patent Document 1 includes only several battery units, configuring a higher-power power storage system requires a larger number of battery units to be housed. For such medium- to large-size power storage systems, a configuration is conceivable in which a plurality of battery units are disposed side by side in a stationary accommodating rack etc. and terminals of adjacent battery units are cabled with each other, for example.

However, in such a configuration, not only is cable wiring work during mounting battery units time-consuming, but maintenance also involves complicated work of temporarily removing cables and wiring the cables again after repairing or replacing a battery unit concerned.

Having been devised in view of the above problem, the present invention aims to provide a battery shelf assembly, which is excellent in work efficiency of mounting battery units as well as in maintainability, a power storage system, and an assembling method of a battery shelf assembly.

### SOLUTION TO PROBLEM

A battery shelf assembly of one embodiment of the present invention for achieving the above aim is as follows:
1. A battery shelf assembly, comprising:
   a plurality of battery units having a storage battery;
   a battery shelf accommodating the battery units, configured such that the battery units are mounted or dismounted by sliding movement in the battery shelf; and
   a power connector connecting the battery unit and the battery shelf so that power of the battery unit can be output, wherein
   the power connector comprises:
      a first connector member disposed at an electrode terminal of the battery unit;
      a second connector member, disposed on the battery shelf, configured to connect with the first connector member; and
      a floating structure that absorbs a position gap between the first and second connector members..

### (Terms)

"Battery unit" has one or more chargeable and rechargeable storage batteries (battery cells), and is sometimes called a "battery module" etc.

"Battery shelf" is a case for accommodating battery units, and is typically a box-shaped case having an opening in one part through which the battery units are inserted. Various forms of battery shelves other than the box-shaped one are possible as long as they have the function of housing and retaining battery units.

### ADVANTAGE OF THE INVENTION

According to the present invention, it is possible to provide a battery shelf assembly, which is excellent in work efficiency of mounting battery units as well as in maintainability, a power storage system, and an assembling method of a battery shelf assembly.

### BRIEF DESCRIPTION OF DRAWINGS

Fig. 1 is a front view of a power storage system according to one embodiment.
Fig. 2 is a rear view of a power storage system according to one embodiment.
Fig. 3 is a perspective view showing how a battery shelf assembly is loaded into a rack.
Fig. 4 is a perspective view showing the configuration of the rack.
Fig. 5 is a perspective view showing how a battery unit is loaded into a battery shelf.
Fig. 6 is a perspective view showing the external appearance (front view) of the battery shelf assembly.
Fig. 7 is a perspective view showing the external appearance (rear view) of the battery shelf assembly.
Fig. 8 is a perspective view showing the configuration of a floating connector.
Fig. 9 is a partially enlarged view of the rack from its rear side.

### DESCRIPTION OF EMBODIMENTS

Embodiments of the present invention will be described with reference to drawings. In the drawings, components having the same function are assigned the same reference numbers or corresponding reference numbers.

### (Overall configuration)

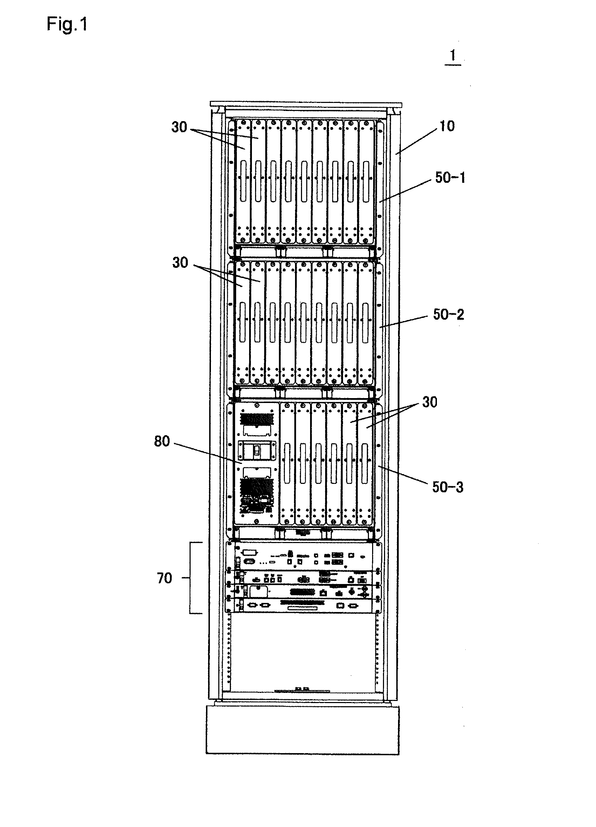

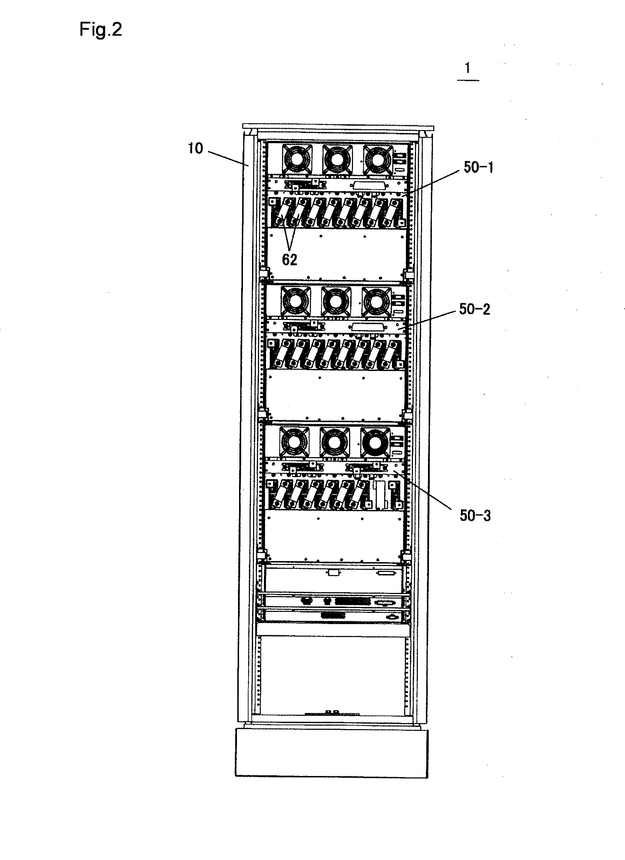

As shown in Fig. 1 to Fig. 3, a storage battery system 1 of this embodiment has a rack 10 and a plurality of battery shelf assemblies 50-1 to 50-3 (hereinafter also called simply a "battery shelf assembly 50") disposed in the rack 10. In this example, three battery shelf assemblies 50-1 to 50-3 are disposed in three tiers. A control unit 70 is disposed under these battery shelf assemblies 50.

Battery shelf assembly 50 refers to a battery shelf 55, a housing case, loaded with a plurality of battery units 30 (to be described in detail later). The battery shelf assemblies 50-1 to 50-3 are basically the same in configuration. In the battery shelf assembly 50-3 in the bottom tier of the three, a breaker unit 80 is disposed in place of a part of the battery units 30.

The control unit 70 is configured to control operations of the power storage system 1, and is composed of one or more control devices.

The storage battery system 1 as a whole has at least one of the following functions:
(a) supplying power from the battery units 30 to any external device or system;
(b) charging each battery unit 30 upon receiving a power supply from the outside;
(c) controlling timing of start/stop of charge and discharge, or monitoring the state of each battery unit 30 by means of the control unit 70 and the breaker unit 80;
(d) determining whether or not temperature of one or more battery units 30 is within a proper range, by using functions of the control unit 70 and the breaker unit 80;
(e) determining whether or not there is any defect in one or more battery units 30, by using functions of the control unit 70 and the breaker unit 80; and
(f) determining, for a certain battery unit 30, how much the battery unit has been used and determining on this basis whether or not replacement is necessary, by using functions of the control unit 70 and the breaker unit 80.

Although the number of the battery units 30 is not particularly limited, in this embodiment, three shelves accommodate a total of 24 battery units 30, all of which are electrically connected in series. It is not necessary that all units are connected in series, and, for example, combination of series connection and parallel connection may be used.

### (Rack)

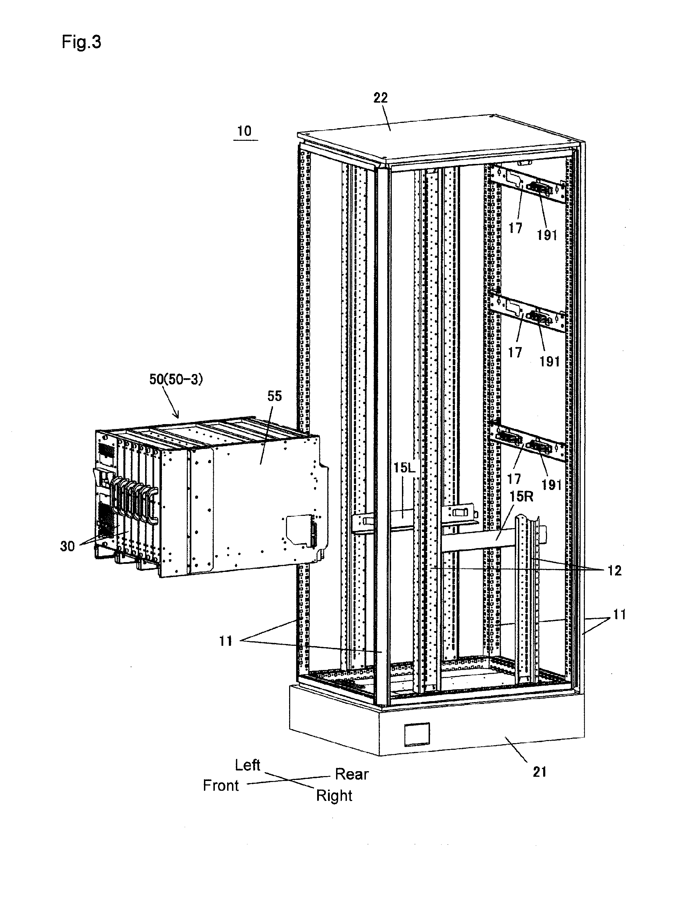

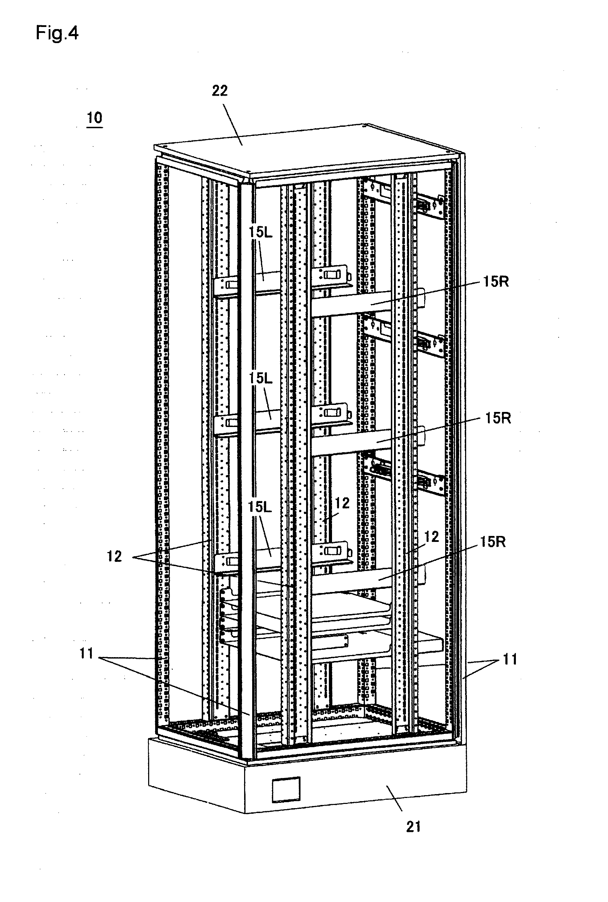

As shown in Fig. 3 and Fig. 4, rack 10 has a support base 21, struts 11 positioned at four corners of the support base, and a top plate 22 mounted on top of the struts 11. Rack 10 forms an accommodating space in a shape of substantially vertically long cuboid. Rack 10 also has inner struts 12 disposed two on each of the left and right sides. Retaining plates 15L, 15R are disposed on two adjacent inner struts 12 substantially horizontally, the retaining plate is configured to retain battery shelf assembly 50. In this case, a pair of retaining plates 15L, 15R retain battery shelf assembly 50 at both ends of the bottom surface.

Pair of retaining plates 15L, 15R are provided at three positions in vertical direction as shown in Fig. 4 to accommodate three tiers of battery shelf assemblies 50, With no limitation intended, the retaining plates 15L, 15R may be a metal member which is L-shaped in cross-section and has sufficient rigidity. According to such a configuration, when the battery shelf 55 is mounted, the shelf can be moved to the back side while being slid on the horizontal surfaces of the retaining plates 15L, 15R. Retaining plates 15L, 15R may be attached on inner struts 12 by using screws, bolts, etc.

It is preferable that the inner strut 12 has a plurality of screw holes formed in vertical direction which enable mounting positions (in height direction) of the retaining plates 15L, 15R to be adjustable. Accordingly, various sizes of battery shelf assemblies can be accommodated. Depending on a size for battery shelf assembly, a number of tiers of rack may be two or less or four or more.

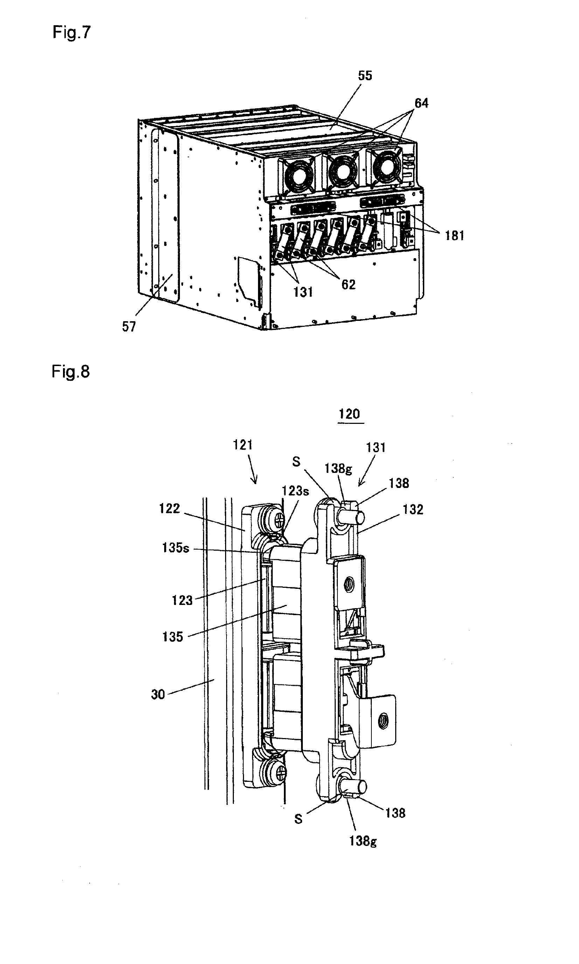

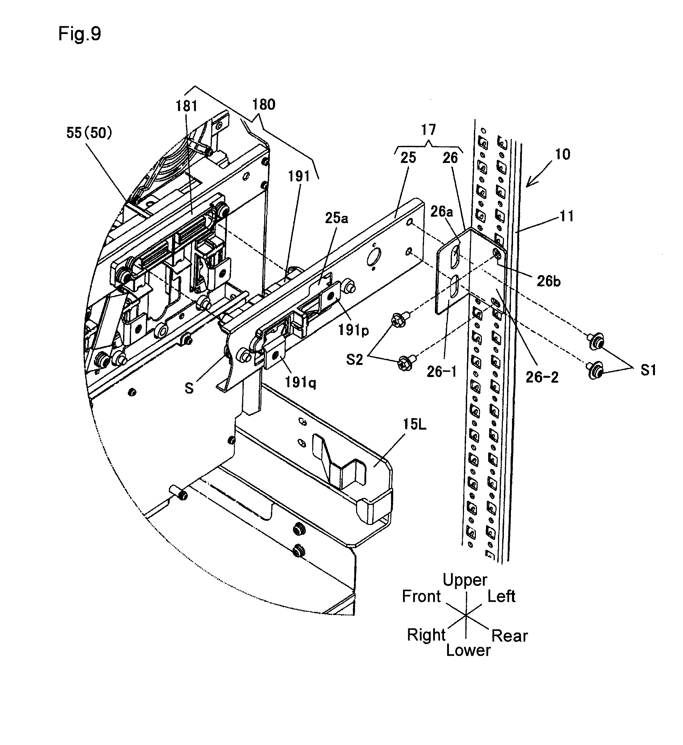

As shown in Fig. 3, the other connector 191 is disposed on a back side of the rack 10, to which a rear connector members 181 (see Fig. 7) on the battery shelf assemblies 50 is connected. Specifically, a bracket 17, laterally long plate, is disposed on two struts 11 on the left and right sides, and the bracket 17 supports the other connector 191. Fig. 9 shows a power supply connector (floating connector) 180 that includes the rear connector 181 and the other connector 191.

"Floating structure" refers to a structure in which one connector member is configured to be movable relative to the other connector member to thereby absorb displacement (e.g., 1 mm or larger, 2 mm or larger, 3 mm or larger, or 5 mm or larger) in relative positions of the connector members. "Floating connector" refers to a connector having such a floating structure.

Bracket 17 may be of any shape which can retain the other connector 191, and the bracket is not limited to the plate-like shape. Bracket 17 may be configured to be movable in front-back direction, left-right direction, and/or vertical direction, etc. (to be described in detail below).

Example of the specific configuration will be described with reference to Fig. 9. As shown in the drawing, bracket 17 has a support member 25, on which the other connector 191 is mounted, and a coupling member 26 which couples the support member 25 to the strut 11 of the rack 10.

In this example, the support member 25 is an elongated member extending in left-right direction. With no limitation intended, support member 25 may be a metal member having a substantially concave-shaped cross-section. Connector 191 is fixed on the support member 25 with screws or bolts S, and in this state, a part of the connector 191 (connection terminals 191p, 191q, etc.) protrudes to rear side through an opening 25a of the support member 25.

Coupling members 26 are attached respectively to both ends of the support member 25 (only one is shown in Fig. 9). As an example, the coupling member 20 is a metal member having an L-shaped cross-section, with a flat surfaces 26-1 extending in vertical direction and left-right direction, and a flat surface 26-2 extending in vertical direction and front-back direction.

Two elongated holes 26a extending in vertical direction are formed in the flat surface 26-1. Screws S1 are passed through these elongated holes 26a, and the leading end sides of the screws S1 are screwed into screw holes in the end portion of the support member 25. Since longitudinal dimension and lateral dimension of the elongated hole 26a are sufficiently large relative to shaft diameter of the screw S1, even after the screw is tightened, the support member 25 is movable in all the directions of the vertical direction, the left-right direction, and the oblique direction. Movability range may be 1 mm to several mm.

In the flat surface 26-2, two round holes 26b having a relatively large diameter are formed. Screws S2 are passed through these round holes 26b, and the leading end sides of the screws S2 are screwed into screw holes formed in the strut 11. Since the inner diameter of the round hole 26b is sufficiently large relative to the shaft diameter of the screw S2, even after the screw is tightened, the coupling member 26 (and the entire bracket 17) is movable in vertical direction, front-back direction, etc. In this case, too, movability range may be 1 mm to several mm.

### (Battery shelf assembly)

In the following, the configuration of the battery shelf assembly 50 will be described in detail.

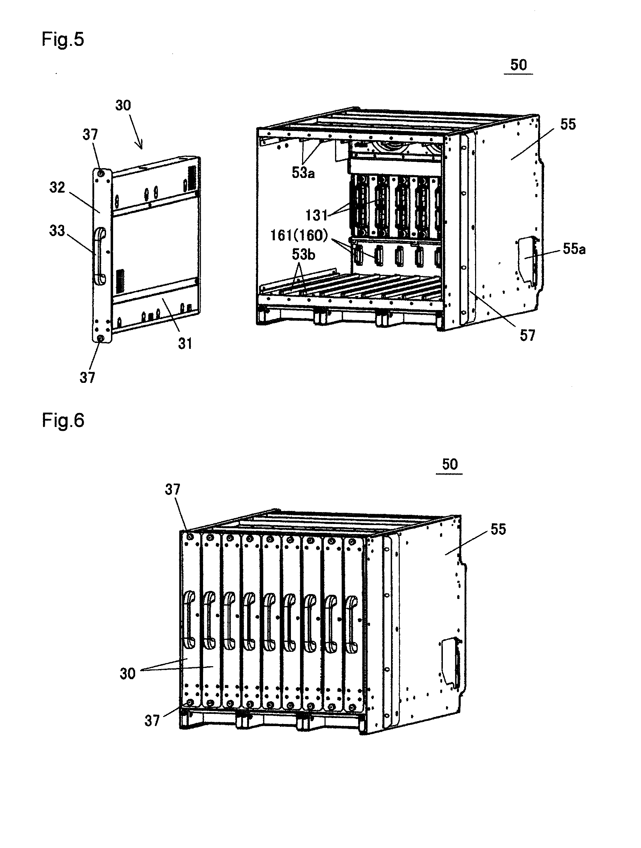

As shown in Fig. 5 to Fig. 7, a battery shelf assembly 50 includes a plurality of battery units 30 and a battery shelf 55 accommodating them.

The battery unit 30 has a plurality of battery cells (not shown) disposed inside a casing 31 having a thin, vertically long shape as a whole. A front plate 32 is disposed on the front the casing 31, and a handle 33 is disposed approximately at the center of the plate 32. Upper end and lower end of the front plate 32 are configured to be fixed on a part of the battery shelf 55 after the battery units 30 are set inside the battery shelf 55. Fixing means may be fixing screws 37, for example.

The battery unit 30 may have a sensor (not shown) for detecting temperature of the battery cells inside or an electronic circuit (not shown) for outputting a detection result to the outside. On the rear surface of the casing 31, a power connector (Fig. 8; to be described in detail later) and a signal connector (not shown) are provided.

Battery shelf 55 will be described. As shown in Fig. 5, the battery shelf 55 is formed in the shape of a box with an open front, and has side surfaces, an upper surface, a lower surface, and a rear surface. Each of the side surfaces is provided with one fixing plate 57 (only the right side is shown) to fix the battery shelf 55 on the rack 10.

In this embodiment, the battery unit 30 is configured to be inserted while being slid into the battery shelf 55, and for guiding purpose (for the insertion along a guide groove), the upper surface and the lower surface inside the battery shelf 55 are provided with guide members 53a, 53b. With no limitation intended, the guide members 53a, 53b may be straight members disposed parallel to one another.

A connector with a floating structure (floating connector) electrically connects the battery unit 30 and the battery shelf 55. This will be described in the following.

Fig. 8 is a perspective view illustrating the structure of the floating connector. As shown in Fig. 8, the connector 120 has a non-movable connector member 121 which is mounted on the battery unit 30 side, and a movable connector member 131 which is mounted on the shelf 55. As an example, each connector member 121, 131 may be made of a resin.

Non-movable connector member 121 is disposed at an electrode terminal of the battery unit 30. The non-movable connector member 121 has a base part 122 and a recessed part 123 formed in the base part 122. The recessed part 123 is a part into which a plug part 135 of the other connector member 131 is inserted as will be described below, and a taper part 123s is formed at inlet portion of the recessed part 123. A hole (not shown) is formed at each of the upper end and the lower end respectively of the base part 122. Fixing screws passed through the holes fix the non-movable connector member 121 to the rear surface of the battery unit 30.

Movable connector member 131 has a base part 132 and a plug part 135 protruding from the base part. The external shape of the plug part 135 corresponds to the recessed part 123 of the non-movable connector member 121. In order to facilitate insertion of the plug part 135 into the recessed part 123, the plug part 135 has a taper part 135s at its distal end, that makes the plug part 135 a tapered shape.

While in the connector 120 of Fig. 8, the plug part 135 is inserted into the recessed part 123 in the shown direction, it is also preferable, in order to prevent incorrect connection, that the connector 120 has such a structure that the plug part 135 cannot be inserted upside down into the recessed part 123.

Floating structure of the connector 120 of this embodiment is configured by forming the taper part 135s at distal end portion of the plug part 135 and using the movable connector member 131 configured to be movable as will be described below. As shown in Fig. 8, substantially U-shaped mounting parts 138 are formed at the upper end and the lower end of the base part 132 of the movable connector member 131. A gap 138g inside the mounting part 138 is sufficiently larger than a diameter of the fixing screw S. The movable connector member 131 is, in other words, tacked between the two fixing screws S. Such a configuration enables the connector member 131 to be movable, to some extent, in all the directions of vertical direction, left-right direction, and oblique direction. Range of movability in this case may be 1 mm to several mm, although it depends on the size of the entire connector 120, the size of the battery unit 30, etc.

Directions in which a movable connector member is movable may be one or a combination of vertical direction, left-right direction, and oblique direction, instead of all these directions. The configuration which allows movement of the movable connector member can be changed in various ways, and is not limited to the structure of Fig. 8. For example, a gap 138g of mounting part 138 may be a closed circular hole or elongated hole. Further examples of the connector member will be described later.

Moreover, the movable connector member 131 may be configured to be movable not only in vertical direction, left-right direction, and oblique direction, etc. within one plane but also in front-back direction (in one or a combination of vertical direction, left-right direction, oblique direction, and front-back direction). Range of movability may be about 1 mm to several mm, for example. In terms of the example of Fig. 8, the neck portion (the portion having a relatively large diameter) of the fixing screw S may be longer than the thickness of the mounting part 138 so that the movable connector member 131 is movable in the front-back direction, for example, by one mm to several mm.

Fig. 5 is referred to again. Movable connector members 131 configured as described above are disposed on a rear surface of the battery shelf 55, aligned in lateral direction. As shown in Fig. 7, part of the movable connector member 131 is exposed to the outside of the rear surface of the battery shelf 55, and adjacent movable connectors 131 are connected with each other through a flexible wire 62. The flexible wire 62 is a strip-like conductive member provided with a connection member at both ends. In this embodiment, the flexible wire 62 is mounted obliquely to connect upper end of one movable connector member 131 and lower end of the other movable connector member 131.

In this way, the battery units 30 are connected in series. Power of the battery shelf assemblies as a whole is output through a rear connector member 181 disposed at a power terminal part (not shown) on the rear surface of the battery shelf. The rear connector member 181 is identical to the non-movable connector member 121 of Fig. 8. In this example, rear connector members 181 are each mounted in lateral direction and disposed side by side respectively on the right and left sides.

As shown in Fig. 3, the other connector member 191 is disposed in the bracket 17 of the rack 10. This connector member 191 is identical to the movable connector member 131 shown in Fig. 8. Due to this configuration, connection between the battery shelf 55 and the rack 10 is also made through floating connector. With no limitation intended, the connector members 191 are connected with each other through a connection cord etc. in advance.

A signal connector 160 (see Fig. 5) for exchanging electrical signals with the battery unit 50 will be described. For example, a floating connector for a known electrical device may be used for the signal connector 160, and the signal connector is composed of a connector member 161 mounted on the battery shelf 55 side and another connector member (not shown) mounted on the battery unit 30 side.

In the present embodiment, power connector (connector member 131 in Fig. 5) and signal connector (connector member 161 in Fig. 5) are disposed with predetermined distance in vertical direction. Such a configuration, the power line and the signal line are separated from each other, can prevent generating a power source noise

Signal line (not shown) from the signal connector member 161 may be connected with external control means etc. through an opening 55a formed in a side surface of the battery shelf 55.

Without particularly limiting the present invention, an accommodating space may be formed in a bottom surface portion of the battery shelf 55, for example, and a BMU (control circuit: battery management unit) may be disposed there.

As shown in Fig. 7, a plurality of cooling fans 64 for cooling the battery units 30 inside the battery shelf 55 may be provided in an upper portion of the rear surface of the shelf.

The battery shelf assembly 50 configured as described above has the following functions:
(a) outputting power corresponding to the number of the battery units 30, and charging the battery units 30 at a predetermined timing;
(b) allowing input and output of electrical signals for each battery unit 30 through a signal line (not shown); and
(c) driving the cooling fans 64 at a predetermined timing to cool the battery units 30.

### (Example of assembly procedure)

Next, an assembling method of the power storage system 1 of this embodiment will be described. The assembling method described below is merely an example of the present invention, and the present invention is not limited in any way by its procedure etc.

First, the rack 10 (Fig. 4) is assembled at a planned installation position of the power storage system 1, and, the battery shelf 55 is mounted on the rack 10 for example before being loaded with the battery units 30. To mount the battery shelf 55, the battery shelf 55 is moved from the front side to the back side of the rack, and the rear connector member 181 of the battery shelf 55 and the other connector member 191 on the rack side are connected with each other. Then the battery shelf 55 and the rack 10 are connected with fixing members such as screw and bolt.

As shown in Fig. 9, the bracket 17 in this embodiment is movable at least in the front-back direction by about several mm. Therefore, even when, for example, there is some backward deviation in position of the battery shelf 55 from a predetermined position, it is possible to properly connect the rear connector member 181 and the other connector member 191 with each other while absorbing position gap, as the bracket 17 shifts backward, . That is, in this embodiment, it is possible to absorb position gap of the connector members 181, 191 by both the movable structures of the floating connector 180 and the bracket 17.

Next, the battery units 30 are loaded into the fixed battery shelf 55 one by one. Specifically, a user picks up the battery unit 30 and inserts it by sliding into the battery shelf 55. During this process, since the guide members 53a, 53b are formed in the upper surface and the lower surface inside the shelf, due to the guiding action, the battery unit 30 can be inserted straight.

Even when there is some misalignment between the non-movable connector member 121 on the battery unit 30 side and the movable connector member 131 on the shelf 55 side, it is possible to properly connecting the connectors with each other while absorbing position gap by means of the floating connector 120. With the signal connector 160, too, it is possible to connect the connector properly while absorbing position gap with the floating structure.

After the connector members 121, 131 have been connected with each other and the battery units 30 have been loaded into the battery shelf 55 through these steps, the upper end and the lower end of the front plate 32 are fixed on the battery shelf 55 with the fixing screws 37. Subsequently, loading other battery units 30 by the same procedure completes the assembly of the battery shelf assembly 50.

Further, the other two battery shelf assemblies 50 can also be assembled by the same procedure (for the battery shelf assembly 50-3, the breaker unit 80 is mounted). After all the three battery shelf assemblies 50 have been assembled, predetermined electric wiring work is performed, which completes the power storage system 1 of this embodiment. Examples of the predetermined electric wiring work include connecting the signal line from each battery shelf 50 with the control unit 75 fixed on the rack 10.

According to the battery shelf assembly 50 of this embodiment as has been described above, the power connector 120 and the signal connector 160 are connected with each other for electrical connection simply by inserting the battery units 30 by sliding into the battery shelf 55. Such a configuration does not require connecting the battery units 30 with one another through a cable etc. by user. In addition, the maintainability is excellent in that, even when it is necessary to replace or repair a predetermined battery unit 30, simply pulling the battery unit 30 toward oneself after removing the fixing screws 37 etc. can release the electrical connection and remove the battery unit.

Furthermore, since the floating connector is used for the power connector 120 and the signal connector 160, even when some position gap exists in relative positions of the connector members, it is possible to properly connect the connectors while absorbing the gap.

According to the floating connector 120 (see Fig. 8) as illustrated in this embodiment, it is possible to absorb position gap in all directions of vertical direction, left-right direction, and oblique direction.

When the non-movable connector member 121 is disposed in the battery unit 30 and the movable connector member 131 is disposed in the battery shelf 55, there is the following advantage. That is, since it is necessary to build the floating structure in the movable connector member 131, the movable connector member 131 typically has a larger size than the non-movable connector member 121. Accordingly, it is possible to reduce the size of the entire battery unit 30 by providing the non-movable connector member 131, which can be made relatively smaller, on the battery unit 30 side.

When the recessed part 123, into which the plug part 135 of the movable connector member 131 is inserted, is disposed in the non-movable connector member 121, ease of handling of the battery unit 30 improves, since a part such as the plug part 135 does not protrude from the battery unit 30.

Disposing the power connector 120 and the signal connector 160 at a distance from each other as in this embodiment can prevent generation of noise in the signal line due to the influence of the power line.

### (Other embodiments)

While one form of the present invention has been described with reference to the drawings, the present invention is not limited to the above-described form but can be changed in various ways.
(a) In the above example, the configuration has been shown in which the plurality of battery units 30 are disposed laterally; however, for example, the plurality of battery units may be stacked in vertical direction, or may be disposed in a matrix arrangement.
(b) In the above example, the configuration has been shown in which both the power connector and the signal connector are a floating connector; however, only either one may be a floating connector.
(c) In the above example, the movable connector member of the floating connector is disposed on the shelf side and the non-movable connector member is disposed on the battery unit side; however, conversely, the movable connector member may be disposed on the battery unit side and the non-movable connector member may be disposed on the shelf side. Such a change is applicable to one or both of the power connector and the signal connector.
(d) In the above example, the configuration has been shown in which the plug part 135 is formed in the movable connector member 131; however, the plug part (protruding part) may be formed in the non-movable connector member 121, and each of the plug parts may be inserted into a recessed part of the movable connector member 131.
(e) The connection form of the batteries is not limited to series connection, various forms of connection can be adopted such as connecting at least part of the battery units in parallel, and connecting the shelves in parallel.
(f) The rear connector member 181 of Fig. 7 may be provided in a vertical position instead of a lateral position.
(g) The number of the racks 10 is not limited to one, two or more racks 10 may be disposed which are electrically connected with one another in series or in parallel. The racks 10 may be separated from or adjacent to one another.
(h) Regarding the configuration of Fig. 9, the shapes of the support member 25 and the coupling member 26 can be appropriately changed. For example, any material, shape, etc. may be adopted for the support member 25 as long as it has the sufficient rigidity not to be significantly bent when connector members are connected with each other. For the coupling member 26, too, various materials and shapes can be adopted other than the metal member having an L-shaped cross-section as shown in the drawing.
(i) The round hole 26b of the coupling member 26 may be a elongated hole so that the bracket 17 is movable at least in the front-back direction.
(j) A biasing member (e.g., a spring etc.) may be provided for biasing the bracket 17 forward.

The present application also discloses the following inventions:
1. A battery shelf assembly, comprising:
   a plurality of battery units having a storage battery;
   a battery shelf accommodating the battery units, configured such that the battery units are mounted or dismounted by sliding movement in the battery shelf; and
   a power connector connecting the battery unit and the battery shelf so that power of the battery unit can be output, wherein
   the power connector comprises:
      a first connector member disposed at an electrode terminal of the battery unit;
      a second connector member, disposed on the battery shelf, configured to connect with the first connector member; and
      a floating structure that absorbs a position gap between the first and second connector members..
2. The battery shelf assembly described above, wherein the floating structure absorbs position gap (i) in at least one of vertical direction, left-right direction, and an oblique direction, or (ii) in at least one of vertical direction, left-right direction, oblique direction, and front-back direction.
3. The battery shelf assembly described above, wherein
   the first connector member of the battery unit is non-movable member, and
   the second connector member of the battery shelf is movable member.
4. The battery shelf assembly described above, wherein
   the movable member has a plug part, and the non-movable member has a recessed part into which the plug part is inserted, and
   a taper part is formed at least at distal end of the plug part.
5. The battery shelf assembly described above, wherein
   the battery unit has an electronic circuit, the battery shelf assembly further comprising:
   a signal connector exchanging electrical signals with the electronic circuit, the signal connector comprising:
      a first signal connector member disposed on the battery unit;
      a second signal connector member disposed on the battery shelf; and
      a floating structure that absorbs a position gap between both connector members..
6. The battery shelf assembly described above, wherein the signal connector and the power connector are disposed at a predetermined distance.
7. The battery shelf assembly described above, further comprising:
   an electrode terminal, formed in a shelf rear surface, for outputting power of the battery shelf assembly as a whole, said electrode terminal has a rear connector member which, with the other connector, configures a floating connector.
8. The battery shelf assembly described above, wherein the rear connector is a non-movable member.
9. A power storage system comprising:
   at least one battery shelf assembly described above; and
   a rack in which the battery shelf assembly is accommodated.
10. A method of assembling a battery shelf assembly by mounting battery units having a storage battery into a battery shelf, wherein the battery shelf assembly comprising a power connector having a first connector member disposed at an electrode terminal of the battery unit, a second connector member, disposed on the battery shelf, configured to connect with the first connector member; and a floating structure that absorbs a position gap between the first and second connector members, the method comprising the steps of:
   (a) inserting the battery units by sliding into the battery shelf; and
   (b) connecting the first and the second connector with each other while absorbing position gap in relative positions of the first and second connectors by the power connector.

### DESCRIPTION OF THE REFERENCE NUMERALS

- 1: POWER STORAGE SYSTEM
- 10: RACK
- 11: STRUT
- 12: INNER STRUT
- 15L, 15R: RETAINING PLATE
- 17: BRACKET
- 21: SUPPORT BASE
- 22: TOP PLATE
- 25: SUPPORT MEMBER
- 25A: OPENING
- 26: COUPLING MEMBER
- 26A: ELONGATED HOLE
- 26B: ROUND HOLE
- 30: BATTERY UNIT
- 31: CASING
- 32: FRONT PLATE
- 33: HANDLE
- 37: FIXING SCREW
- 50: BATTERY SHELF ASSEMBLY
- 53A, 53B: GUIDE MEMBER
- 55: BATTERY SHELF
- 62: FLEXIBLE WIRE
- 64: COOLING FAN
- 70: CONTROL UNIT
- 80: BREAKER UNIT
- 120: POWER CONNECTOR
- 121: NON-MOVABLE CONNECTOR MEMBER
- 122: BASE PART
- 123: RECESSED PART
- 123S: TAPER PART
- 131: MOVABLE CONNECTOR MEMBER
- 132: BASE PART
- 135: PLUG PART
- 135S: TAPER PART
- 138: MOUNTING PART
- 138G: GAP
- 160: SIGNAL CONNECTOR
- 161: CONNECTOR MEMBER
- 180: POWER CONNECTOR
- 181: REAR CONNECTOR MEMBER
- 191: THE OTHER CONNECTOR MEMBER
- 191P, 191Q: CONNECTION TERMINAL
- S: FIXING SCREW

## Claims

1. A battery shelf assembly, comprising:
a plurality of battery units having a storage battery;
a battery shelf accommodating the battery units, configured such that the battery units are mounted or dismounted by sliding movement in the battery shelf; and
a power connector connecting the battery unit and the battery shelf so that power of the battery unit can be output, wherein
the power connector comprises:
a first connector member disposed at an electrode terminal of the battery unit;
a second connector member, disposed on the battery shelf, configured to connect with the first connector member; and
a floating structure that absorbs a position gap between the first and second connector members.

2. The battery shelf assembly according to claim 1, wherein the floating structure absorbs position gap (i) in at least one of vertical direction, left-right direction, and an oblique direction, or (ii) in at least one of vertical direction, left-right direction, oblique direction, and front-back direction.

3. The battery shelf assembly according to claim 1 or 2, wherein
the first connector member of the battery unit is non-movable member, and
the second connector member of the battery shelf is movable member.

4. The battery shelf assembly according to claim 3, wherein the movable member has a plug part, and the non-movable member has a recessed part into which the plug part is inserted, and a taper part is formed at least at distal end of the plug part.

5. The battery shelf assembly according to any one of claims 1 to 4, wherein the battery unit has an electronic circuit, the battery shelf assembly further comprising:
a signal connector exchanging electrical signals with the electronic circuit, the signal connector comprising:
a first signal connector member disposed on the battery unit;
a second signal connector member disposed on the battery shelf, and
a floating structure that absorbs a position gap between both connector members.

6. The battery shelf assembly according to claim 5, wherein the signal connector and the power connector are disposed at a predetermined distance.

7. The battery shelf assembly according to any one of claims 1 to 6, further comprising:
an electrode terminal, formed in a shelf rear surface, for outputting power of the battery shelf assembly as a whole, said electrode terminal has a rear connector member which, with the other connector, configures a floating connector.

8. The battery shelf assembly according to claim 7, wherein the rear connector is a non-movable member.

9. A power storage system comprising:
at least one battery shelf assembly according to any one of claims 1 to 8; and
a rack in which the battery shelf assembly is accommodated.

10. A method of assembling a battery shelf assembly by mounting battery units having a storage battery into a battery shelf, wherein the battery shelf assembly comprising a power connector having a first connector member disposed at an electrode terminal of the battery unit, a second connector member, disposed on the battery shelf, configured to connect with the first connector member; and a floating structure that absorbs a position gap between the first and second connector members, the method comprising the steps of:
(a) inserting the battery units by sliding into the battery shelf; and
(b) connecting the first and the second connector with each other while absorbing position gap in relative positions of the first and second connectors by the power connector.
